# EUROPEAN PATENT APPLICATION

(11) **EP 4 734 737 A1**
(43) Date of publication of application: **29.04.2026**
(21) Application number: 25210732.1
(22) Date of filing: 23.10.2025
(51) Int. Cl.: H10P 58/00

(54) **LASER-LESS DICING METHOD**

(30) Priority: 25.10.2024 US 202418926736
(71) Applicant: NXP USA, Inc., Austin, TX 78735 (US)
(72) Inventor: Mirpuri, Kabir, 5656AG Eindhoven (NL); Aguinaga, Alexander Ryan, 5656AG Eindhoven (NL); Schmitt, Adam Louis Clayton, 5656AG Eindhoven (NL)
(74) Representative: Colaiuda, Antonella

(57) **Abstract**

Techniques for processing a wafer involve patterning the wafer to define via locations within dies of the wafer and simultaneously define saw street indentation locations within saw street regions of the wafer. The saw street regions are disposed between the dies of the wafer. Such techniques further involve creating a set of indentations within the wafer. The set of indentations includes via indentations at the via locations within the dies configured to support electrically conductive interconnects and saw street indentations at the saw street indentation locations within the saw street regions configured to facilitate dicing.

## Description

### TECHNICAL FIELD

This disclosure relates generally to wafer processing, and more particularly to creating indentations in a wafer for facilitating singulation.

### BACKGROUND

Singulation is the process of separating a wafer into individual dies. Typically, singulation involves separating dies along a grid or other pattern of spaces between dies commonly referred to as saw streets or scribe lines. One dicing method is sawing along the saw streets.

Other methods selectively weaken the wafer in the saw streets to facilitate singulation by cleaving the wafer along the saw streets. For example, laser dicing equipment may direct a laser beam at the saw streets to form cracks within the saw streets. Some laser dicing equipment may focus a laser beam inside the thickness of the wafer such that cracks form internally within the wafer rather than on a surface of the wafer, thereby reducing debris, chipping, and the like.

### BRIEF DESCRIPTION OF THE DRAWINGS

The foregoing and other objects, features and advantages will be apparent from the following description of particular embodiments of the present disclosure, as illustrated in the accompanying drawings in which like reference characters refer to the same parts throughout the different views. The drawings are not necessarily to scale, emphasis instead being placed upon illustrating the principles of various embodiments of the present disclosure.
FIG. 1 is a view of an example wafer having saw street indentations created while forming via indentations for electrically conductive interconnects in accordance with one or more embodiments.
FIG. 2 is a back side view of a portion of the example wafer in accordance with one or more embodiments.
FIG. 3 is a cross-sectional side view of the portion of the example wafer in accordance with one or more embodiments.
FIG. 4 is a flowchart of wafer processing procedure that creates saw street indentations to facilitate dicing and via indentations for electrically conductive interconnects in accordance with one or more embodiments.
FIG. 5 is a view of the portion of the example wafer with a metal seed layer in accordance with one or more embodiments.
FIG. 6 is a view of the portion of the example wafer with a metal die pad in accordance with one or more embodiments.
FIG. 7 is a view of a processing system having a stage that performs the wafer processing procedure in accordance with one or more embodiments.
FIG. 8 is a view of a portion of a wafer having saw street indentations and a trench which are created while forming via indentations for electrically conductive interconnects in accordance with one or more embodiments.
FIG. 9 is a view of a tool for creating top side saw street indentations in accordance with one or more embodiments.

### DETAILED DESCRIPTION

Some laser dicing methods include using a laser beam to cut through a wafer. Other methods include using a laser to form cracks or other mechanically weakened areas within a wafer to facilitate singulation of dies by preferentially cleaving the wafer at the weakened areas. However, the laser dicing equipment that controls the laser beam requires frequent maintenance (e.g., daily), significant startup time (e.g., one hour), and custom dicing recipes, which may be based on particular die sizes, wafer thickness, etc. Additionally, the laser dicing equipment may be prone to yield loss unless high laser precision is consistently maintained. Unfortunately, alternatives such as mechanical wafer sawing or wafer cutting (e.g., using a cutting blade to cut through the wafer) require frequent blade maintenance, promote chipping, and may have less precision than that of the laser dicing equipment. Reduced precision may necessitate wider saw streets, which can subtract from the area available for semiconductor dies. What is needed, therefore, is a way to effectively singulate dies without requiring a laser or mechanical saw. Preferably, such methods should also not require additional complicated processing steps.

The above need is addressed at least in part by creating saw street indentations in a wafer to facilitate dicing using process steps that are used to create electrically conductive vias on the back side of the wafer and at the same time. For example, a mask layer on the back side of the wafer which exposes locations for plasma etching of via indentations may be adjusted to further expose locations of saw street indentations for plasma etching of saw street indentations. After the saw street indentations are created, the dies may be separated without the need of a laser and/or mechanical sawing (e.g., by instead using tape expansion, breaking, combinations thereof, etc.).

The various individual features of the particular arrangements, configurations, and embodiments disclosed herein can be combined in any desired manner that makes technological sense. Additionally, such features are hereby combined in this manner to form all possible combinations, variants and permutations except to the extent that such combinations, variants and/or permutations have been expressly excluded or are impractical. Support for such combinations, variants and permutations is considered to exist in this document.

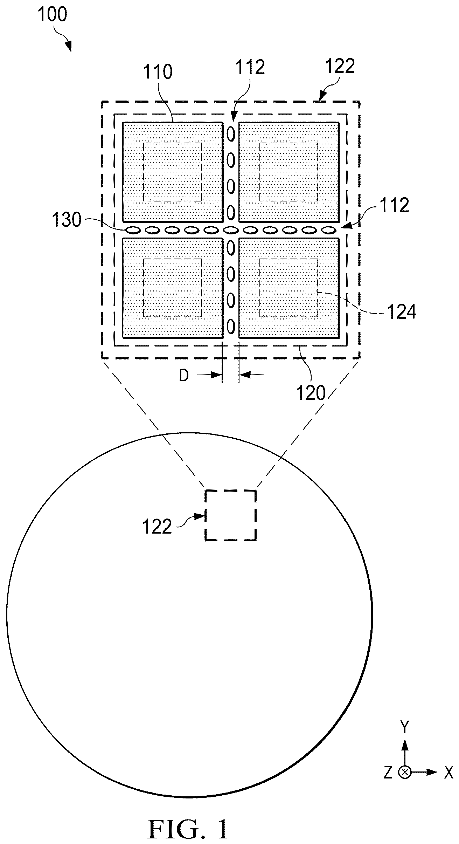

FIG. 1 shows a view of a wafer 100 in accordance with one or more embodiments. The wafer 100 includes semiconductor dies 110 and saw street regions 112 between the semiconductor dies 110 as illustrated by the insert 120 showing wafer details of an example wafer section 122.

The semiconductor dies 110 are arranged in an array (e.g., rows and columns). By way of example only, the semiconductor dies 110 are shown as having a square geometry. It should be understood, though, that other die geometries are suitable for use, as well (e.g., rectangular, hexagonal, irregular, etc.). As will be explained in further detail shortly, the semiconductor dies 110 include vias disposed within via areas 124.

The semiconductor dies 110, once packaged into semiconductor devices, are constructed and arranged to perform useful work. Example semiconductor devices include integrated circuits, discrete devices, microelectromechanical systems (MEMS), combinations thereof, and the like.

The saw street regions 112 provide spaces between the semiconductor dies 110 and form parts of the wafer 100 that are acted upon when separating the semiconductor dies 110. In the arrangement of rows and columns of semiconductor dies 110 shown in FIG. 1, the saw street regions 112 extend linearly within the wafer 100 in the X and Y directions.

It should be appreciated that the number of semiconductor dies 110 that fit on the wafer 100 is inversely proportional to the width of the saw street regions 112, which may be set to a predefined saw street distance (D). Accordingly, narrower predefined saw street distances (D) may result in greater numbers of dies per wafer.

Non-limiting examples of suitable widths for the predefined saw street distance (D) are within the range of 15 µm (micrometers) to 30 µm (e.g., 18 µm, 20 µm, 22 µm, 24 µm, etc.). As will be explained in further detail below, a process is disclosed which creates saw street indentations 130 within the saw street regions 112 to facilitate dicing. Such saw street indentations 130 are created using the same processes and at the same time as forming via indentations for vias within the via areas 124.

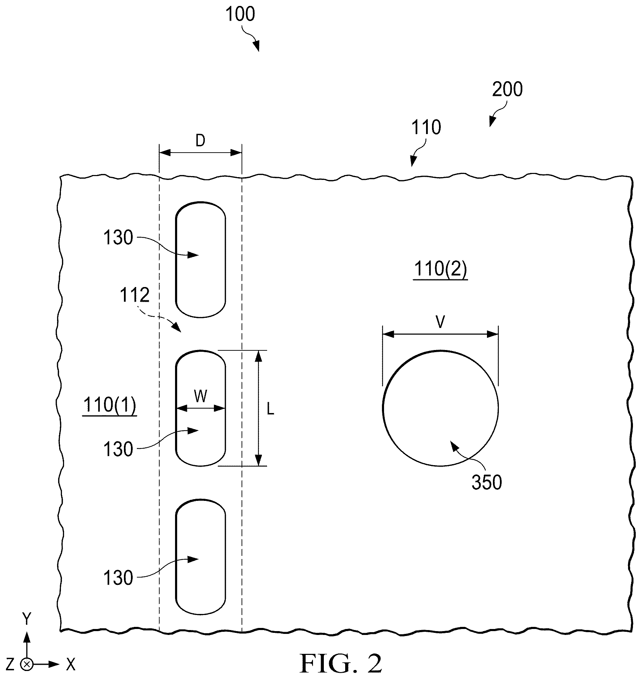

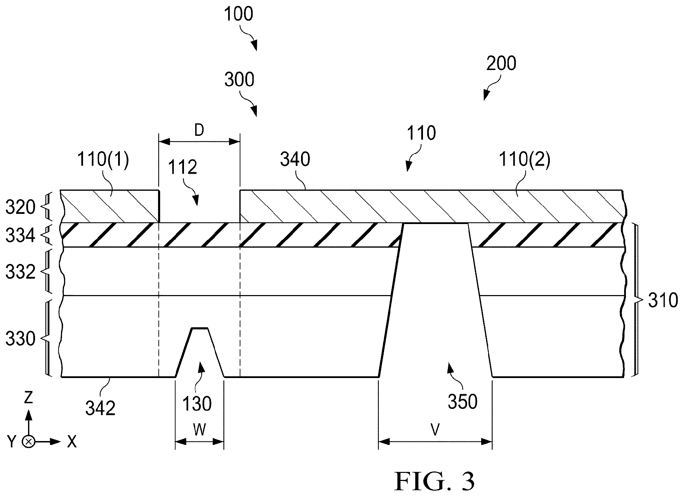

FIGS. 2 and 3 show views of a portion 200 of the wafer 100 in accordance with one or more embodiments (also see FIG. 1). FIG. 2 is a bottom view of the portion 200. FIG. 3 is a cross-sectional side view of the portion 200.

The portion 200 of the wafer 100 includes part of a first semiconductor die 110(1), part of a second semiconductor die 110(2), and part of a saw street region 112, which is disposed between the first and second semiconductor dies 110(1), 110(2) and extends linearly along the Y-axis. The saw street indentations 130 (also see FIG. 1) remain within the saw street region 112 and are aligned (e.g., as a series) along the Y-axis to facilitate dicing. Since the saw street indentations 130 remain within the saw street region 112, the presence of the saw street indentations 130 does not cross into or otherwise interfere with the semiconductor dies 110.

As best seen in FIG. 3, the wafer 100 is formed by multiple layers 300 produced by various semiconductor fabrication processes (e.g., deposition, patterning, doping, etching, etc.). Among the layers 300 are a substrate layer 310 and top side device layers 320 disposed on the substrate layer 310.

The substrate layer 310 serves as supporting material onto which the top side device layers 320 are formed. Example materials for the substrate layer 310 include silicon (Si), silicon carbide (SiC), gallium nitride (GaN), gallium arsenide (GaAs), aluminum nitride (AlN), combinations thereof, and the like.

In accordance with one or more embodiments, the substrate layer 310 includes the initial substrate material 330 and one or more other structures formed thereon and/or therein such as a semiconductor heterostructure. For instance, a gallium nitride/aluminum nitride heterostructure can include a GaN buffer/channel 332, an AlGaN barrier 334, etc. Example thicknesses for the substrate 310 are within a range of 100-500 µm.

The top side device layers 320 are exposed on what is considered to be a top side 340 of the wafer 100 which is opposite a back side 342 of the wafer 100. Along these lines, the top side 340 of the wafer 100 faces in the positive Z-direction, and the back side 342 of the wafer 100 faces in the negative Z-direction.

As shown in FIGS. 2 and 3, a via indentation 350 and saw street indentions 130 extend into the wafer 100 through the back side 342. The via indentation 350 is a hole within the substrate layer 310 which will eventually be filled with metal to form an electrically conductive interconnect for electrical access to the semiconductor die 110(2). For example, the via indentation 350 may form a TSV (through-substate via). Additionally, the saw street indentations 130 are holes within the substrate layer 310 which facilitate wafer dicing (e.g., separating the semiconductor dies 110(1), 110(2) from each other).

It should be understood that the via indentation 350 as shown in FIGS. 2 and 3 appears to be relatively close to the saw street region 112 to enable a convenient side-by-side comparison of certain via indentation and saw street indentation details. However, in one or more embodiments, the via indentation 350 (and perhaps other via indentations 350 within the same die 120) are positioned further away from the saw street indentations 130 (e.g., see the via areas 124 in FIG. 1).

In accordance with one or more embodiments, the saw street indentations 130 are formed using the same process steps that form the via indentations 350. Along these lines, the same patterning and etching steps, etc., that are performed to remove substrate material from the semiconductor dies 120 to form the via indentations 350 within the semiconductor dies 110 of the wafer 100 are also used to remove additional substrate material from the saw street regions 112 for forming the saw street indentations 130. For example, the via indentation 350 and the saw street indentations 130 may be formed contemporaneously using the same dry etching process to remove substrate material from the back side 342 of the wafer 100. Accordingly, there is no need for laser dicing and/or mechanical sawing.

As further shown in FIGS. 2 and 3, the saw street region 112 separates the semiconductor dies 110 by a predefined saw street distance (D). If the predefined saw street distance (D) is narrower, more semiconductor dies 110 can be fit within the wafer 100.

As further shown in FIG. 2 and in accordance with one or more embodiments, the saw street indentations 130 have an oval (or oblong) shape as viewed on the wafer surface (e.g., as viewed on the back side 342 when looking in the negative Z-direction). In particular, the saw street indentations 130 have indentation lengths (L) in a direction along the saw street region 112 (e.g., along the linear path of the saw street region 112) and indentation widths (W) perpendicular to the indentation lengths (L) (e.g., perpendicular to the linear path of the saw street region 112). However, the saw street indentations 130 may also be round, square, rectangular, or other shapes, for example.

In accordance with one or more embodiments, the indentation widths (W) of the saw street indentations 130 are less than the predefined saw street distance (D), and the indentation lengths (L) of the saw street indentations 130 are greater than the predefined saw street distance (D). For example, if the predefined saw street distance (D) is 20 µm, the indentation lengths (L) may be 35 µm and the indentation widths may be 15 µm. Other dimensions are suitable for use as well.

In accordance with one or more embodiments, the via indentations 350 have via indentation diameters (V) which are greater than the predefined saw street distance (D). For example, if the predefined saw street distance (D) is 20 µm, the via indentation diameters (V) for the via indentations 350 may be 70 µm.

In accordance with one or more embodiments, the via indentations 350 are larger than the saw street indentations 130. It should be appreciated that the relatively smaller saw street indentations 130 enable the saw street indentations 130 to remain within the saw street regions 112 without necessitating an increase in the predefined saw street distance (D).

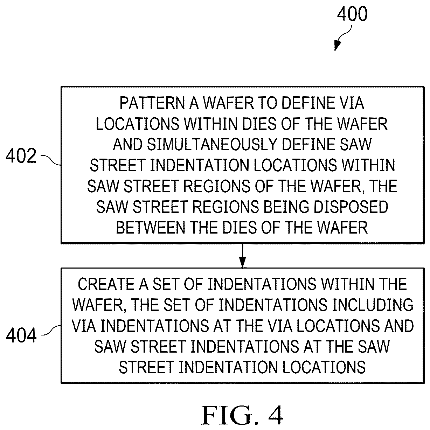

In accordance with one or more embodiments, the via indentations 350 extend deeper into the wafer 100 than the saw street indentations 130. Along these lines, the via indentations 350 may penetrate entirely through the substrate layer 310 (FIG. 3) to reach the top side device layers 320, while the saw street indentations 130 do not penetrate entirely through the substrate layer 310. Further details will now be provided with reference to FIG. 4.

FIG. 4 is a flowchart of an example procedure 400 which enables dicing of a wafer without using a laser or a saw, according to one or more embodiments. Along these lines, the procedure 400 creates saw street indentations within saw street regions while simultaneously creating via indentations for electrically conductive interconnects using the same process.

At 402, processing equipment patterns the wafer to define via locations within dies of the wafer and simultaneously define saw street indentation locations within saw street regions of the wafer. The saw street regions are disposed between the dies of the wafer.

Here, the processing equipment may receive and orient the wafer to expose the back side. The processing equipment is then able to define the via locations and saw street indentation locations using a set of photomasks (or reticles).

It should be appreciated that a set of photomasks that simply defines via locations may be adapted to further define the saw street indentation locations within the saw street regions and thereby identify both the saw street indentation locations and the via locations on the back side of the wafer.

At 404, the processing equipment creates a set of indentations within the wafer. The set of indentations includes via indentations at the via locations within the dies configured to support electrically conductive interconnects and saw street indentations at the saw street indentation locations within the saw street regions configured to facilitate dicing.

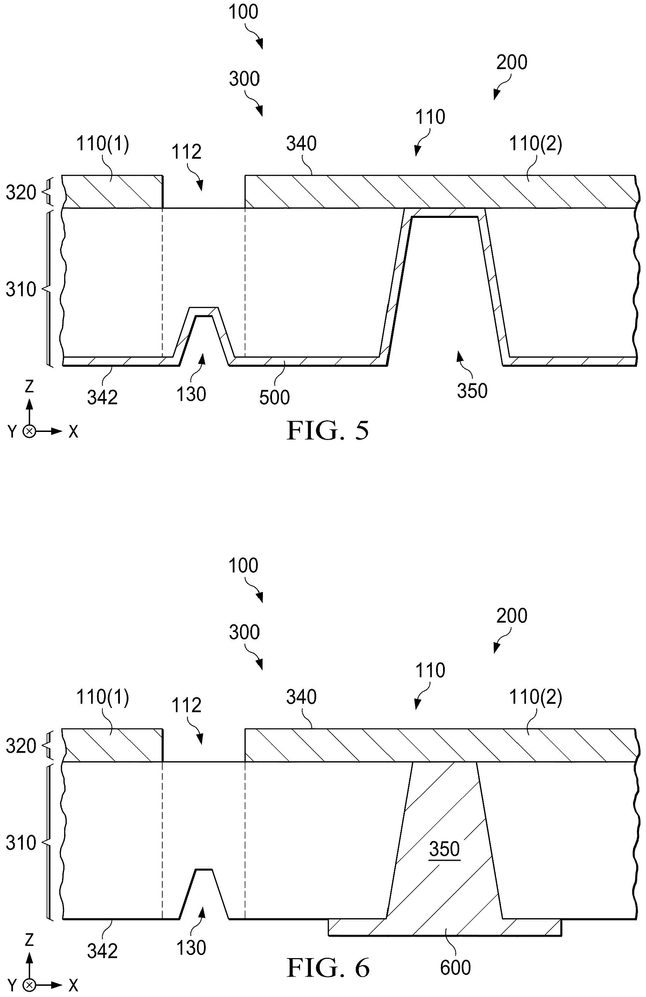

It should be appreciated that the processing equipment which performs the procedure 400 may be part of a larger processing system. However, with creation of the saw street indentations, the larger processing system does not require use of a laser beam or saw to achieve die singulation. Further details will now be provided with reference to FIGS. 5 and 6.

FIGS. 5 and 6 shows certain details for forming an electrically conductive interconnect within the via indentation 350 of the portion 200 of the wafer 100 (also see FIG. 3). FIG. 5 shows the portion 200 with a metal seed layer 500, and FIG. 6 shows the portion 200 with a metal die pad 600.

As shown in FIG. 5, after the saw street indentations 130 and the via indentation 350 are formed on the back side 342 of the wafer 100, equipment may deposit a metal seed layer 500 over the substrate layer 310 as a precursor to adding electrically conductive interconnects (e.g., metallic contacts or pads) to the semiconductor dies 110. Along these lines, such equipment coats the outer surface of the substrate layer 310 with metallic material. Accordingly, at this point, the metal seed layer 500 is effectively the back side of the wafer 100 although, as will be explained in further detail below, the metal seed layer 500 is eventually removed.

In one or more embodiments, the metal seed layer 500 is deposited across the whole wafer 100. Accordingly, the metal seed layer 500 covers the wafer surface including the saw street indentations 130 and the via indentations 350.

Once the metal seed layer 500 has been deposited over the substrate layer 310, various metallic structures may be formed on the wafer 100. For example, metal die pads may be formed within the via indentations 350 of the semiconductor dies 110.

As shown in FIG. 6, a metal die pad 600 is grown or otherwise formed within the via indentation 350 (e.g., via an electroplating process or any other suitable process). According to one or more embodiments, selective etching is performed to remove unwanted parts of the metal seed layer 500 to define areas where additional metal will not be formed. Such unwanted parts may include metal within the saw street regions 112, including metal with the saw-street indentations 130. In an example, the metal die pads 600 are not removed and thus remain.

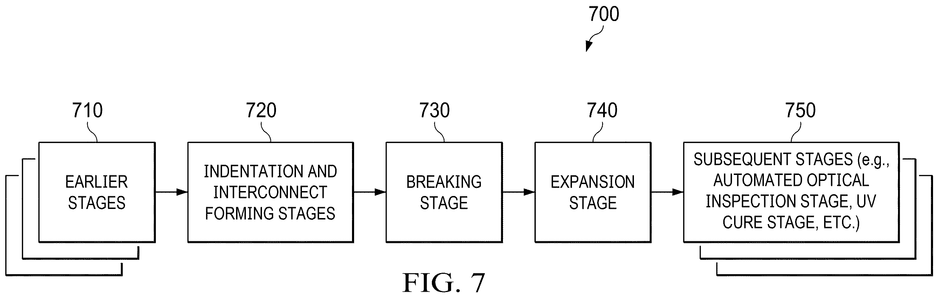

FIG. 7 shows a processing system 700 which includes a stage that performs the procedure 400 (also see FIG. 4) and additional processes to form electrically conductive interconnects (also see FIGS. 5 and 6) as part of the flow in accordance with one or more embodiments. The processing system 700 includes earlier stages 710, indentation and interconnect forming stages 720, a breaking stage 730, an expansion stage 740, and subsequent stages 750 (e.g., an automated optical inspection stage, an ultraviolet cure stage, etc.). The processing system 700 is well suited for processing wafers of various substrate materials, such as Si, SiC, silicon-on-insulator, or other substrate materials.

The earlier stages 710 are constructed and arranged to provide a wafer that is ready for indentation formation. Along these lines, the earlier stages 710 may include various wafer fabrication equipment, such as that used for photomasking, doping, deposition, etching, etc. Accordingly, the output from the earlier stages 710 is a wafer having dies and saw street regions.

The indentation and interconnect forming stages 720 are constructed and arranged to form via indentations and saw street indentations on the wafer (also see FIGS. 1 through 3). Along these lines, the indentation and interconnect forming stages 720 may include specialized equipment that performs the procedure 400 (also see FIG. 4).

Additionally, the indentation and interconnect forming stages 720 are constructed and arranged to form electrically conductive interconnects within the via indentations (also see FIGS. 5 and 6). Accordingly, the output from the indentation and interconnect forming stages 720 is a wafer having dies, saw street regions, indentations within the dies and the saw street regions (also see FIGS. 1 through 3), and electrically conductive interconnects.

It should be appreciated that the equipment which forms the indentation and interconnect forming stages 720 may include lithography equipment (including photomasking equipment), dry etching equipment, cleaning equipment, deposition equipment, and so on. However, laser dicing equipment is not necessary.

The breaking stage 730 is constructed and arranged to break (or fracture) the wafer along the saw street indentations 130 within the saw street regions 112. Here, the wafer is placed on a tape (or die attach film) which is made taut using a grip ring, while clamping members hold a portion of the wafer in place. In some examples, a deflecting member (or blade) is pressed onto an adjacent portion of the wafer to slightly deflect the adjacent portion, causing one or more saw street regions to fracture. The deflecting member translates across the wafer to continue fracturing other saw street regions. In some arrangements, the portions are separated using a 3-point breaking technique. Accordingly, the output from the breaking stage 730 is a wafer having fractures along the saw street indentations within the saw street regions.

The expansion stage 740 is constructed and arranged to separate the dies of the wafer from each other. Along these lines, with the saw street regions now fractured and while the wafer is still on the tape, the tape is expanded. In particular, while the tape is taut on the grip ring, the tape is further stretched in multiple directions. Such further expansion of the tape pulls the dies apart. Accordingly, the output from the expansion stage 740 is a plurality of singulated (or separated) semiconductor dies.

The subsequent stages 750 are constructed and arranged to perform further processing. For example, the subsequent stages 750 may include equipment to perform automated optical inspection (AOI), ultraviolet (UV) curing, testing, packaging, and so on.

It should be understood that one or more of stages may be omitted from the processing system 700, modified, and/or added to the processing system 700. For example, for certain substrate materials such as Si, it may be unnecessary to process the wafer through the breaking stage 730 and the breaking stage 730 may thus be omitted since tape expansion may be sufficient to effectively and efficiently achieve singulation. As another example, the indentation and interconnect forming stages 720 may be modified to further form other features within the wafer such as trenches within the saw street regions of the wafer to further facilitate singulation.

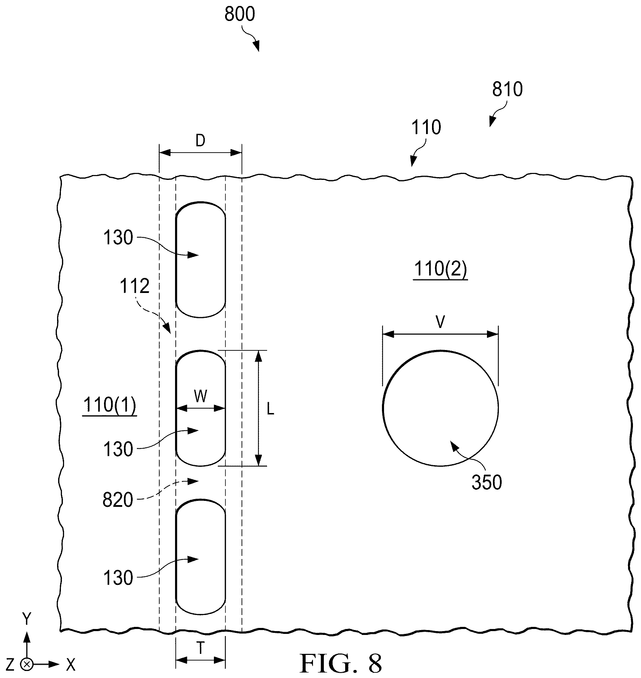

FIG. 8 is a bottom view of a portion 800 of a wafer 810. The portion 800 is similar to the portion 200 of the wafer 100 (also see FIG. 2) in that the portion 800 of the wafer 810 includes a saw street region 112 with saw street indentations 130. However, the portion 800 of the wafer 810 differs from the portion 200 in that the portion 800 further includes a saw street trench 820 that extends along at least a portion of the saw street region 112 (e.g., a channel having a depth that goes partway through the thickness of the wafer 800 with the saw street indentations 130 going deeper). Such a trench 820 may be formed through one or more of the saw street regions 112 of the wafer 810 by the same equipment that forms the saw street indentations 130 and the via indentations 350 and at the same time. For example, the trench 820 has a depth that extends partway through the thickness of the wafer 100 along a length of the saw street region 112, with the saw street indentations 130 extending to a greater depth.

In one or more embodiments, the width (T) of the trench 820 is the same as the widths (W) of saw street indentations 130. For example, if the predefined saw street distance (D) is 20 µm, both the width (T) of the trench 620 and the widths (W) of saw street indentations 130 may be 15 µm. As another example, the trench 820 may have the same aspect ratio as the via indentation 350.

In one or more other embodiments, the width (T) of the trench 820 is greater than the widths (W) of saw street indentations 130 to further facilitate dicing. In yet one or more other embodiments, the width (T) of the trench 820 is narrower than the widths (W) of saw street indentations 130 to make the wafer 810 less susceptible to registration imprecisions.

As mentioned earlier, one or more other stages may be added to the processing system 700 (FIG. 5). An example of a stage that may be added to the processing system 700 is a stage which forms indentations along the saw street regions on the top side of a wafer.

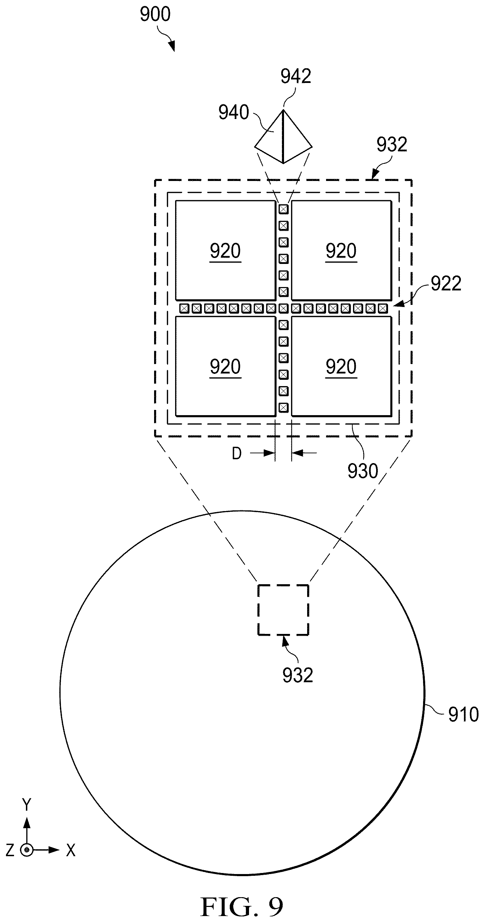

FIG. 9 shows a view of a tool 900 in accordance with one or more embodiments. The tool 900 includes a base 910 which defines open areas 920 and saw street regions 922 between the open areas 920. This arrangement is illustrated by insert 930, which shows tool details of an example tool section 932. Suitable materials for the base 910 include a film, a metallic disc, etc.

The open areas 920 mirror the semiconductor dies of a wafer (e.g., see FIG. 1). For example, when the semiconductor dies are arranged in an array (e.g., rows along the X-axis and columns along the Y-axis), the open areas 920 are arranged in a similar array such that the open areas 920 align with the semiconductor dies of the wafer and the saw street regions 922 align with the saw street regions of the wafer.

Within the saw street regions 922 of the tool 900 reside protrusions (or teeth) 940 which extend in the positive Z-direction. In an example, the protrusions 940 are arranged single file within the saw street regions 922 of the tool 900.

In one or more embodiments, the protrusions 940 have a pyramid shape with a pointed end 942. Along these lines, the protrusions 940 may take the form of diamond pyramid crystals which are secured to the base 910 within the saw street regions 922. Such features provide durability enabling the tool 900 to be reused on multiple wafers.

During operation, such as within a stage of the processing system 700 (FIG. 7), the tool 900 is pressed onto the top side 340 (FIG. 3) of a wafer such that the saw street regions 922 of the tool 900 align with the saw street regions of the wafer (e.g., see the wafer 100 of FIG. 1). Accordingly, the protrusions 940 within the saw street regions 922 create indentations within the top side of the wafer along the saw street regions.

After the tool 900 is applied to the wafer, the tool 900 is removed from the wafer. As mentioned earlier, the tool 900 may then be reapplied to another wafer to form top side saw street indentions in the other wafer.

Such processing forms top side indentations within the saw street regions of wafers. Accordingly, wafers may have saw street indentations extending into the saw street regions from both the top sides of the wafers and the bottom sides of the wafers.

In one or more embodiments, a top side indentation stage resides between the indentation and interconnect forming stages 720 and the breaking stage 730. Accordingly, a wafer provided to the breaking stage 730 may have indentations within the saw street regions on both the back side (also see FIG. 3) and the top side.

It should be understood that such a top side indentation stage may reside in other locations within the processing system 700. For example, the tool 900 may be applied to a wafer to form top side saw street indentations prior to forming back side saw street indentations in the wafer. As yet other examples, the tool 900 may be applied to form top side saw street indentations only, or to form top side saw street indentations with just trenches (e.g., see FIG. 8).

As described above, saw street indentations are created within a wafer to facilitate dicing. Along these lines, processes that are used to create via indentations on the back side of a wafer for electrically conductive interconnects (e.g., lithography, etching, etc.) may be leveraged to form the saw street indentations at the same time. For example, a mask layer on the back side of the wafer which exposes via locations within the dies for plasma etching via indentations may be adjusted to further expose saw street indentation locations within the saw streets for plasma etching saw street indentations. After the saw street indentations are created, the dies may be separated without the need of a laser and/or mechanical sawing (e.g., by instead using tape expansion, breaking, combinations thereof, etc.).

While various embodiments of the present disclosure have been particularly shown and described, it will be understood by those skilled in the art that various changes in form and details may be made therein without departing from the scope of the present disclosure. Such modifications and enhancements are intended to belong to various embodiments of the disclosure.

It should be appreciated that SiC/Si wafers typically employ a costly laser dicing process to enable the separation of the die on the wafer. The laser dicing process creates an internal modified/perforated layer in the saw streets of the wafer. However, the laser dicing process typically requires daily maintenance, start-up time, recipe development per die size/thickness and has opportunity for error leading to yield loss.

In accordance with one or more embodiments, a laser-less process targets a perforation strategy by creating indentations along saw street regions. A three-point breaking blade may then apply pressure along the trajectory of these indentations along the saw street regions thus avoiding need for laser.

In accordance with one or more embodiments, after front side layers are created on a wafer, the wafer is flipped upside down on a glass carrier. Backside via indentations for back metal pads are then etched in a long dry plasma etch process. The via indentations themselves are defined by a film resist, e.g., at 70x30um. The saw street indentations leverage the same process at the same time, e.g., at the size of 35x15um (same aspect ratio). Both interconnect via indentation and saw street indentation sizes are on the same wafer mask as well. Since the saw street indentations are smaller, they will etch at a shallower depth.

Certain embodiments are directed to a method of processing a wafer. The method includes patterning the wafer to define via locations within dies of the wafer and simultaneously define saw street indentation locations within saw street regions of the wafer, the saw street regions being disposed between the dies of the wafer. The method further includes creating a set of indentations within the wafer, the set of indentations including via indentations at the via locations within the dies configured to support electrically conductive interconnects and saw street indentations at the saw street indentation locations within the saw street regions configured to facilitate dicing.

In accordance with one or more embodiments, creating the set of indentations within the wafer includes etching the wafer to selectively remove wafer material from the dies at the via locations and from the saw street indentation locations within the saw street regions.

In accordance with one or more embodiments, the wafer includes a substrate layer and device layers disposed on the substrate layer. Additionally, etching the wafer includes plasma etching substrate material from the substrate layer to contemporaneously form the via indentations at the via locations and the saw street indentations at the saw street indentation locations.

In accordance with one or more embodiments, the wafer includes a substrate layer and device layers disposed on the substrate layer, the device layers being exposed on a top side of the wafer. Additionally, etching the wafer includes removing substrate layer material from a back side of the wafer, the back side of the wafer being opposite the top side of the wafer.

In accordance with one or more embodiments, the dies include a first die and a second die. Additionally, a saw street region separates the first die and the second die by a predefined saw street distance. Furthermore, creating the set of indentations within the wafer includes forming, along a linear path within the saw street region, a row of saw street indentations having indentation lengths in a direction of the linear path and indentation widths perpendicular to the linear path, the indentation widths being less than the predefined saw street distance, and the indentation lengths being greater than the predefined saw street distance.

In accordance with one or more embodiments, the indentation lengths are greater than 20 micrometers and wherein the indentation widths are less than 20 micrometers.

In accordance with one or more embodiments, the via indentations have diameters which are greater than the predefined saw street distance.

In accordance with one or more embodiments, the via indentations are larger than the saw street indentations.

In accordance with one or more embodiments, the via indentations extend deeper into the wafer than the saw street indentations.

In accordance with one or more embodiments, the wafer includes a substrate layer and device layers disposed on the substrate layer. Additionally, the via indentations penetrate through the substrate layer to reach the device layers. Furthermore, the saw street indentations do not penetrate through the substrate layer.

In accordance with one or more embodiments, the method further includes filling the via indentations with metal to form electrically conductive interconnects within the via indentations and preventing filling the saw street indentations with the metal.

In accordance with one or more embodiments, the wafer includes a substrate layer and device layers disposed on the substrate layer, the device layers being exposed on a top side of the wafer. Additionally, the via indentations and the saw street indentations are formed on a back side of the wafer which is opposite the top side of the wafer. Furthermore, the method further includes creating additional saw street indentations on the top side of the wafer within the saw street regions between the dies.

In accordance with one or more embodiments, the wafer includes a substrate layer and device layers disposed on the substrate layer, the device layers being exposed on a top side of the wafer. Additionally, the via indentations and the saw street indentations are formed on a back side of the wafer which is opposite the top side of the wafer. Furthermore, the method further includes creating trenches on the back side of the wafer within the saw street regions between the dies.

In accordance with one or more embodiments, the method further includes applying dicing tape to the wafer and, after the dicing tape is applied to the wafer, expanding the dicing tape to separate the dies.

In accordance with one or more embodiments, the method further includes, prior to expanding the dicing tape, applying a breaker to the wafer to fracture the wafer along the saw street indentations created within the wafer.

In accordance with one or more embodiments, the method further includes, after the dies are separated, packaging the dies to form packaged semiconductor devices.

Certain embodiments are directed to a method of processing a wafer which includes patterning the wafer to define via locations within dies of the wafer and simultaneously define saw street indentation locations within saw street regions of the wafer, the saw street regions being disposed between the dies of the wafer, the wafer including a substrate layer and device layers disposed on the substrate layer, and the device layers being exposed on a top side of the wafer. The method further includes etching substrate layer material from a back side of the wafer to create a set of indentations within the wafer, the back side of the wafer being opposite the top side of the wafer, and the set of indentations including via indentations at the via locations within the dies and saw street indentations at the saw street indentation locations within the saw street regions.

In accordance with one or more embodiments, the dies include a first die and a second die. Additionally, a saw street region separates the first die and the second die by a predefined saw street distance. Furthermore, etching the substrate layer material from the back side of the wafer includes forming, along a linear path within the saw street region, a row of saw street indentations having indentation lengths in a direction of the linear path and indentation widths perpendicular to the linear path, the indentation widths being less than the predefined saw street distance, and the indentation lengths being greater than the predefined saw street distance. Also, the via indentations have diameters which are greater than the predefined saw street distance, the via indentations are larger than the saw street indentations, the via indentations penetrate through the substrate layer to reach the device layers, and the saw street indentations do not penetrate through the substrate layer.

In accordance with one or more embodiments, the method further includes filling the via indentations with metal to form electrically conductive interconnects within the via indentations and preventing filling the saw street indentations with the metal.

In accordance with one or more embodiments, the method further includes, after the electrically conductive interconnects are formed, applying dicing tape to the wafer. Additionally, the method includes, after the dicing tape is applied to the wafer, expanding the dicing tape to separate the dies. Furthermore, the method includes, after the dies are separated, packaging the dies to form packaged semiconductor devices.

The following examples pertain to further embodiments, from which numerous permutations and configurations will be apparent.

Example 1 includes a method of processing a wafer. The method includes patterning the wafer to define via locations within dies of the wafer and simultaneously define saw street indentation locations within saw street regions of the wafer, the saw street regions being disposed between the dies of the wafer. Additionally, the method includes creating a set of indentations within the wafer, the set of indentations including via indentations at the via locations within the dies configured to support electrically conductive interconnects and saw street indentations at the saw street indentation locations within the saw street regions configured to facilitate dicing.

Example 2 includes the subject matter of Example 1 wherein creating the set of indentations within the wafer includes etching the wafer to selectively remove wafer material from the dies at the via locations and from the saw street indentation locations within the saw street regions.

Example 3 includes the subject matter of Example 2 wherein the wafer includes a substrate layer and device layers disposed on the substrate layer. Additionally, etching the wafer includes plasma etching substrate material from the substrate layer to contemporaneously form the via indentations at the via locations and the saw street indentations at the saw street indentation locations.

Example 4 includes the subject matter of Example 2 wherein the wafer includes a substrate layer and device layers disposed on the substrate layer, the device layers being exposed on a top side of the wafer. Additionally, etching the wafer includes removing substrate layer material from a back side of the wafer, the back side of the wafer being opposite the top side of the wafer.

Example 5 includes the subject matter of Example 1 wherein the dies include a first die and a second die. Additionally, a saw street region separates the first die and the second die by a predefined saw street distance. Furthermore, creating the set of indentations within the wafer (or etching) includes forming, along a linear path within the saw street region, a row of saw street indentations having indentation lengths in a direction of the linear path and indentation widths perpendicular to the linear path, the indentation widths being less than the predefined saw street distance, and the indentation lengths being greater than the predefined saw street distance.

Example 6 includes the subject matter of Example 5 the indentation lengths are greater than 20 micrometers and wherein the indentation widths are less than 20 micrometers.

Example 7 includes the subject matter of Example 5 or Example 6 wherein the via indentations have diameters which are greater than the predefined saw street distance.

Example 8 includes the subject matter of any of Examples 1 through 7 wherein the via indentations are larger than the saw street indentations.

Example 9 includes the subject matter of any of Examples 1 through 8 wherein the via indentations extend deeper into the wafer than the saw street indentations.

Example 10 includes the subject matter of any of Example 1 and Examples 5 through 9 wherein the wafer includes a substrate layer and device layers disposed on the substrate layer. Additionally, the via indentations penetrate through the substrate layer to reach the device layers. Furthermore, the saw street indentations do not penetrate through the substrate layer.

Example 11 includes the subject matter of any of Examples 1 through 10 wherein the method further includes filling the via indentations with metal to form electrically conductive interconnects within the via indentations and preventing filling the saw street indentations with the metal.

Example 12 includes the subject matter of any of Example 1 and Examples 5 through 9 wherein the wafer includes a substrate layer and device layers disposed on the substrate layer, the device layers being exposed on a top side of the wafer. Additionally, the via indentations and the saw street indentations are formed on a back side of the wafer which is opposite the top side of the wafer. Also, the method further includes creating additional saw street indentations on the top side of the wafer within the saw street regions between the dies.

Example 13 includes the subject matter of any of Example 1 and Examples 5 through 9 wherein the wafer includes a substrate layer and device layers disposed on the substrate layer, the device layers being exposed on a top side of the wafer. Additionally, the via indentations and the saw street indentations are formed on a back side of the wafer which is opposite the top side of the wafer. Also, the method further includes creating trenches on the back side of the wafer within the saw street regions between the dies.

Example 14 includes the subject matter of any of Examples 1 through 13 wherein the method further includes applying dicing tape to the wafer and, after the dicing tape is applied to the wafer, expanding the dicing tape to separate the dies.

Example 15 includes the subject matter of any of Examples 1 through 14 wherein the method further includes, prior to expanding the dicing tape, applying a breaker to the wafer to fracture the wafer along the saw street indentations created within the wafer.

Example 16 includes the subject matter of any of Examples 1 through 15 wherein the method further includes, after the dies are separated, packaging the dies to form packaged semiconductor devices.

Example 17 includes a method of processing a wafer. The method includes patterning the wafer to define via locations within dies of the wafer and simultaneously define saw street indentation locations within saw street regions of the wafer, the saw street regions being disposed between the dies of the wafer, the wafer including a substrate layer and device layers disposed on the substrate layer, and the device layers being exposed on a top side of the wafer. The method further includes etching substrate layer material from a back side of the wafer to create a set of indentations within the wafer, the back side of the wafer being opposite the top side of the wafer, and the set of indentations including via indentations at the via locations within the dies and saw street indentations at the saw street indentation locations within the saw street regions.

Example 18 includes the subject matter of Example 17 wherein the dies include a first die and a second die. Additionally, a saw street region separates the first die and the second die by a predefined saw street distance. Furthermore, etching the substrate layer material from the back side of the wafer includes forming, along a linear path within the saw street region, a row of saw street indentations having indentation lengths in a direction of the linear path and indentation widths perpendicular to the linear path, the indentation widths being less than the predefined saw street distance, and the indentation lengths being greater than the predefined saw street distance. Also, the via indentations have diameters which are greater than the predefined saw street distance, the via indentations are larger than the saw street indentations, the via indentations penetrate through the substrate layer to reach the device layers, and the saw street indentations do not penetrate through the substrate layer.

Example 19 includes the subject matter of Example 17 or Example 18 wherein the method further includes filling the via indentations with metal to form electrically conductive interconnects within the via indentations and preventing filling the saw street indentations with the metal.

Example 20 includes the subject matter of Example 19 wherein the method further includes, after the electrically conductive interconnects are formed, applying dicing tape to the wafer, after the dicing tape is applied to the wafer, expanding the dicing tape to separate the dies, and after the dies are separated, packaging the dies to form packaged semiconductor devices.

As used throughout this document, the words *"comprising," "including," "containing,"* and *"having"* are intended to set forth certain items, steps, elements, or aspects of something in an open-ended fashion. Also, as used herein and unless a specific statement is made to the contrary, the word *"set"* means one or more of something. This is the case regardless of whether the phrase *"set of"* is followed by a singular or plural object and regardless of whether it is conjugated with a singular or plural verb. Also, a *"set of"* elements can describe fewer than all elements present. Thus, there may be additional elements of the same kind that are not part of the set. Further, ordinal expressions, such as *"first," "second," "third,"* and so on, may be used as adjectives herein for identification purposes. Unless specifically indicated, these ordinal expressions are not intended to imply any ordering or sequence. Thus, for example, a *"second"* event may take place before or after a *"first* event," or even if no first event ever occurs. In addition, an identification herein of a particular element, feature, or act as being a *"first"* such element, feature, or act should not be construed as requiring that there must also be a *"second"* or other such element, feature or act. Rather, the *"first"* item may be the only one. Also, and unless specifically stated to the contrary, *"based on"* is intended to be nonexclusive. Thus, *"based on"* should be interpreted as meaning *"based at least in part on"* unless specifically indicated otherwise. Further, although the term *"user"* as used herein may refer to a human being, the term is also intended to cover non-human entities, such as robots, bots, and other computer-implemented programs and technologies. Although certain embodiments are disclosed herein, it is understood that these are provided by way of example only and should not be construed as limiting.

Also, the foregoing description refers to elements or nodes or features being *"connected"* or *"coupled"* together. As used herein, unless expressly stated otherwise, *"connected"* means that one element is directly joined to (or directly communicates with) another element, and not necessarily mechanically. Likewise, unless expressly stated otherwise, *"coupled"* means that one element is directly or indirectly joined to (or directly or indirectly communicates with, electrically or otherwise) another element, and not necessarily mechanically. Thus, although the schematics and component features shown in the figures depict one exemplary arrangement of elements, additional intervening elements, devices, features, or components may be present in one or more other embodiments of the depicted subject matter.

Those skilled in the art will therefore understand that various changes in form and detail may be made to the embodiments disclosed herein without departing from the scope of the following claims.

## Claims

1. A method of processing a wafer, the method comprising:
patterning the wafer to define via locations within dies of the wafer and simultaneously define saw street indentation locations within saw street regions of the wafer, the saw street regions being disposed between the dies of the wafer; and
creating a set of indentations within the wafer, the set of indentations including via indentations at the via locations within the dies configured to support electrically conductive interconnects and saw street indentations at the saw street indentation locations within the saw street regions configured to facilitate dicing.

2. The method of claim 1 wherein creating the set of indentations within the wafer includes:
etching the wafer to selectively remove wafer material from the dies at the via locations and from the saw street indentation locations within the saw street regions.

3. The method of claim 2 wherein the wafer includes a substrate layer and device
layers disposed on the substrate layer; and
wherein etching the wafer includes:
plasma etching substrate material from the substrate layer to contemporaneously form the via indentations at the via locations and the saw street indentations at the saw street indentation locations.

4. The method of claim 2 wherein the wafer includes a substrate layer and device layers disposed on the substrate layer, the device layers being exposed on
a top side of the wafer; and
wherein etching the wafer includes:
removing substrate layer material from a back side of the wafer,
the back side of the wafer being opposite the top side of the wafer.

5. The method according to any preceding claim, wherein the dies include a first die and a second die;
wherein a saw street region separates the first die and the second die by a predefined saw street distance; and
wherein creating the set of indentations within the wafer includes:
forming, along a linear path within the saw street region, a row of saw street indentations having indentation lengths in a direction of the linear path and indentation widths perpendicular to the linear path, the indentation widths being less than the predefined saw street distance, and the indentation lengths being greater than the predefined saw street distance.

6. The method of claim 5 wherein the indentation lengths are greater than 20 micrometers and wherein the indentation widths are less than 20 micrometers.

7. The method of claim 5 wherein the via indentations have diameters which are greater than the predefined saw street distance.

8. The method of claim 7 wherein the via indentations are larger than the saw street indentations.

9. The method of claim 7 wherein the via indentations extend deeper into the wafer than the saw street indentations.

10. The method of claim 7 wherein the wafer includes a substrate layer and device layers disposed on the substrate layer;
wherein the via indentations penetrate through the substrate layer to reach the device layers; and
wherein the saw street indentations do not penetrate through the substrate layer.

11. The method according to any preceding claim, further comprising:
filling the via indentations with metal to form electrically conductive interconnects within the via indentations and preventing filling the saw street indentations with the metal.

12. The method according to any preceding claim wherein the wafer includes a substrate layer and device layers disposed on the substrate layer, the device layers being exposed on a top side of the wafer;
wherein the via indentations and the saw street indentations are formed on a back side of the wafer which is opposite the top side of the wafer; and
wherein the method further comprises:
creating additional saw street indentations on the top side of the wafer within the saw street regions between the dies.

13. The method according to any preceding claim wherein the wafer includes a substrate layer and device layers disposed on the substrate layer, the device layers being exposed on a top side of the wafer;
wherein the via indentations and the saw street indentations are formed on a back side of the wafer which is opposite the top side of the wafer; and
wherein the method further comprises:
creating trenches on the back side of the wafer within the saw street regions between the dies.

14. The method according to any preceding claim, further comprising:
applying dicing tape to the wafer, and
after the dicing tape is applied to the wafer, expanding the dicing tape to separate the dies.

15. The method of claim 14, further comprising:
prior to expanding the dicing tape, applying a breaker to the wafer to fracture the wafer along the saw street indentations created within the wafer.
